# FASCICULE DE BREVET EUROPEEN

(11) **EP 0 565 451 B1**
(45) Date de publication et mention de la délivrance du brevet: **16.08.1995**
(21) Numéro de dépôt: 93400926.7
(22) Date de dépôt: 08.04.1993
(51) Int. Cl.: H05K 9/00

(54) **Dispositif de contention pour cartes électroniques**
Haltevorrichtung für elektronische Karten
Retaining device for electronic boards

(30) Priorité: 10.04.1992 FR 9204426
(43) Date de publication de la demande: 13.10.1993
(73) Titulaire: ALCATEL RESEAUX D'ENTREPRISE, F-75015 Paris (FR)
(72) Inventeur: Noblet, Dominique, F-78700 Conflans St Honorine (FR)
(74) Mandataire: Schaub, Bernard

(56) Documents cités:
- EP-A- 0 163 174
- US-A- 4 868 955
- US-A- 4 977 483

## Description

La présente invention se rapporte à un dispositif de contention pour cartes électroniques, ou pour autres petits sous-ensembles électriques ou électroniques d'encombrement analogue.

Afin d'assurer dans de bonnes conditions la maintenance des appareils électriques et électroniques, il est à l'heure actuelle considéré comme pratiquement indispensable de respecter certains impératifs de sécurité lors du transport, souvent indispensable, des cartes électroniques ou des autres petits sous-ensembles électriques ou électroniques d'encombrement analogue. Ces cartes et sous-ensembles doivent en effet être protégés au mieux contre les chocs, les vibrations, l'électricité statique, etc...

Pour assurer le transport de ces cartes dans de bonnes conditions de sécurité, on prévoit actuellement des dispositifs d'emballage spécifiquement adaptés à chacune d'elles, ces dispositifs d'emballage étant en général en outre prévus pour se fixer dans des conteneurs spécialement dimensionnés et agencés à cet effet.

Cette solution a pour inconvénient d'être assez onéreuse et de manquer considérablement de souplesse, et à l'heure actuelle on est encore trop souvent amené à transporter les cartes sans utiliser de dispositif de contention particulier, ce qui n'offre bien-entendu aucune garantie de sécurité.

L'invention vise à remédier à cet inconvénient. Elle se rapporte à un dispositif de contention à caractère universel pour cartes électroniques ou autres petits sous-ensembles électriques ou électroniques d'encombrement analogue, ci-après tous appelés "cartes", ce dispositif de contention comportant une plaque de base en matériau antistatique, d'allure générale rectangulaire et de dimensions supérieures à celles d'une grande carte, au moins deux plaques de mousse antistatique étant rapportées sur cette plaque de base de façon à laisser entre elles-deux une rainure sensiblement médiane et reliant deux côtés opposés du rectangle, cette rainure étant de largeur suffisante pour recevoir à plat une ou deux premières sangles élastiques à fermeture rapide qui sont respectivement fixées sur ces côtés opposés de la plaque de base, au moins deux autres sangles ou paires de sangles de même type, mais orthogonales aux premières, étant par ailleurs fixées sur les deux autres côtés opposés de cette plaque de base.

L'invention concerne aussi un conteneur selon la revendication 4.

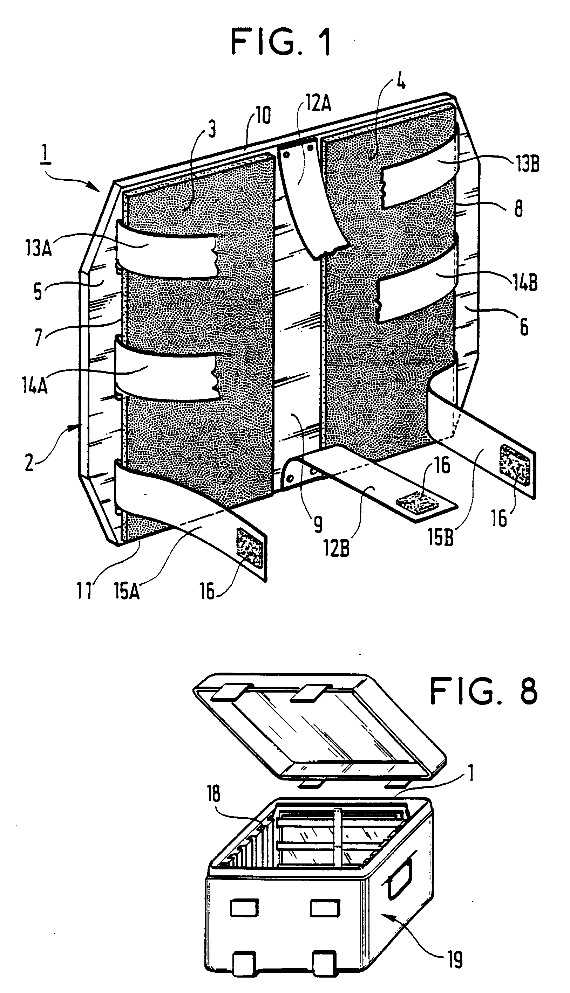

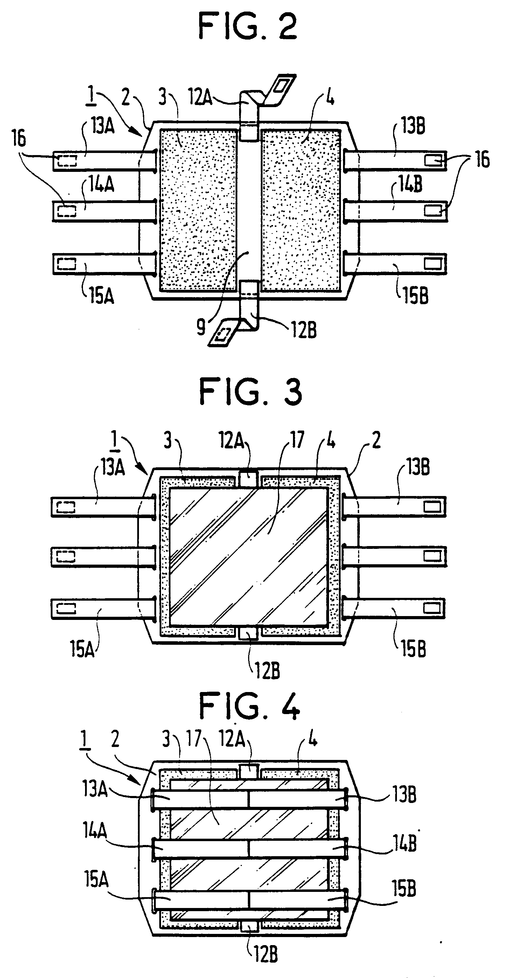

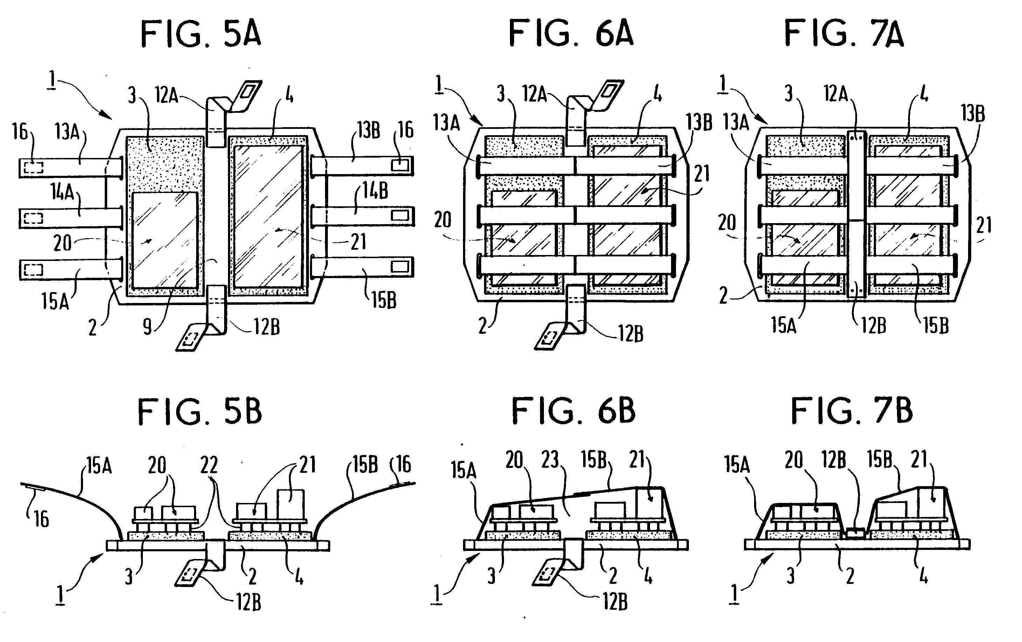

De toute façon, l'invention sera bien comprise, et ses avantages et autres caractéristiques ressortiront, lors de la description suivante d'un exemple non-limitatif de réalisation, en référence au dessin schématique annexé dans lequel :
. Figure 1 est une vue en perspective de ce dispositif de contention.
. Figure 2 à 4 sont des vues en plan, montrant les phases successives de fixation d'une grande carte électronique sur ce même dispositif de contention.
. Figures 5A, 6A, 7A et 5B, 6B, 7B sont respectivement des vues en plan et des vues en bout correspondantes, montrant les phases successives de fixation de deux petites cartes électroniques, différentes en encombrement, côte à côte sur ce dispositif de contention; et
. Figure 8 montre un conteneur de transport de cartes qui est conçu pour recevoir plusieurs de ces dispositifs de contention.

En se reportant aux Figures 1, 2, et 8, ce dispositif de contention, ou support universel de transport 1, pour cartes électroniques ou analogues, se compose d'une plaque de base 2, en bois ou autre matériau antistatique, sur laquelle sont collées deux plaques de mousse antistatique 3, 4.

La plaque de base 2 a une forme de rectangle, avec deux petits prolongements trapèzoïdaux 5 et 6 de part et d'autre des petits côtés 7, 8 du rectangle. Cette plaque 2 est de faible épaisseur, par exemple de l'ordre de 0,5 cm pour fixer les idées.

Les deux plaques de mousse 3, 4 sont identiques, rectangulaires, peu épaisses (0,5 cm par exemple), et elles sont rapportées sur la plaque de bois 2 de façon à laisser entre elles une assez large et peu profonde rainure médiane 9 qui joint les deux grands côtés 10, 11 de la plaque rectangulaire 2.

Quatre paires de sangles élastiques de maintien des cartes sont prévues sur ce support universel 1 :
. Une première paire de sangles élastiques conjuguées 12A,12B qui sont respectivement fixées, au niveau de la rainure médiane 9, sur les grands côtés 10, 11 de la plaque de base 2. Ces sangles sont de largeur légèrement inférieure à celle de la rainure 9 et d'épaisseur égale ou inférieure à la demi-profondeur de cette rainure, c'est à dire à la demi-épaisseur des plaques de mousse 3, 4.
. Trois autres paires de sangles élastiques conjuguées 13A,13B - 14A,14B - 15A,15B, qui sont orthogonales aux premières sangles 12A,12B, et qui sont respectivement fixées sur les petits côtés 7 et 8 du rectangle fermé par la plaque de base 2.

Toutes ces sangles élastiques conjuguées ont leurs extrémités libres pourvues d'attaches rapides conjuguées 16 (Figure 2), par exemple à "velours et crochets", qui permettent après tension de les fixer l'une à l'autre.

Les figures 2 à 4 schématisent l'utilisation de ce support universel de transport 1 pour une carte électronique unique 17, pouvant être de dimensions relativement grandes : dans l'exemple représenté, il s'agit d'une carte rectangulaire de dimensions peu inférieures à celles de la plaque de base 2.

Le support universel 1 est tout d'abord posé à plat avec toutes ses sangles 12A à 15B ouvertes, comme représenté en figure 2.

Puis (figure 3) les deux sangles 12A et 12B sont rabattues tendues l'une sur l'autre et fixées dans cette position, de sorte qu'elles viennent ainsi pratiquement remplir la rainure médiane 9.

La carte électronique 7 est alors posée à plat sur l'ensemble souple formé par les deux plaques de mousse 3, 4 et les deux sangles rabattues 12A, 12B, avec le côté "soudure" contenant les picots d'extrémités de têtes de composants posé sur cet ensemble : de la sorte, ces picots s'implantent dans la mousse et les sangles élastiques, ce qui constitue déjà une fixation mécanique protégeant la carte 17 des vibrations et des chocs.

Les trois autres paires de sangles 13A à 15B sont alors rabattues tendues sur la carte 17 et fixées l'une sur l'autre (figure 4) pour constituer un ensemble final rigide et prêt pour le transport, qui peut (figure 8) être enfiché, grâce aux prolongements 5 et 6 précités (figure 1), dans des rainures 18 prévues à cet effet dans un conteneur de transport 19 apte à recevoir plusieurs de ces supports universels 1, enfichés parallèlement l'un à l'autre.

Les figures 5A à 7B montrent comment est utilisé ce même support universel 1 pour transporter deux cartes électroniques différentes 20, 21, dont la largeur est assez faible pour ne pas dépasser celle des plaques de mousse 3 et 4.

Dans ce cas, les cartes 20 et 21 sont d'abord posées à plat et côte à côte sur le support 1, et plus précisément respectivement sur les plaques de mousse 3 et 4. Toutes les sangles 12A à 15B sont, alors totalement ouvertes (figures 5A et 5B) et, comme récédemment, les cartes 20, 21 sont posées sur la mousse 3, 4 par leur côté soudure, de sorte que les picots 22 des composants viennent se fixer dans celle-ci.

Puis, selon figures 6A et 6B, les trois paires de sangles latérales conjuguées 13A à 15B sont rabattues, tendues, et fixées l'une sur l'autre. Comme on le constate à l'examen de la figure 6B, le maintien des cartes 20 et 21 n'est alors pas encore parfait puisqu'il reste entre elles un vaste espace libre 23 qui ne procure aucun effet de maintien.

On rabat alors (figure 7A), tend, et fixe l'une sur l'autre les deux premières sangles conjuguées 12A et 12B, de sorte qu'ainsi, comme le voit bien en figure 7B, les deux cartes 20 et 21 sont maintenant fermement et distinctement enveloppées, et donc maintenues. Le support 1 peut alors être enfiché dans le conteneur de transport précité 19.

A noter que lorsqu'on désire transporter dans le conteneur 19 du matériel quelconque tout emballé, le support universel 1 peut être utilisé seul comme intercalaire pour caler ce matériel dans le conteneur et éviter ainsi qu'il se déplace au cours du transport.

Comme il va de soi, l'invention n'est pas limitée à l'exemple de réalisation qui vient d'être décrit. C'est ainsi par exemple que le socle de base 2 pourrait être en une matière antistatique autre que le bois et que les prolongements latéraux d'enfichage 5,6 pourraient avoir une forme autre que trapézoïdale.

## Revendications

1. Dispositif de contention à caractère universel pour cartes électroniques (17,20,21) ou autres petits sous-ensembles électriques ou électroniques d'encombrement analogue, ci-après tous appelés "cartes", ce dispositif de contention (1) comportant une plaque de base (2) en matériau antistatique, d'allure générale rectangulaire et de dimensions supérieures à celles d'une grande carte (17), au moins deux plaques de mousse antistatique (3,4) étant rapportées sur cette plaque de base (2) de façon à laisser entre elles-deux une rainure (9) sensiblement médiane et reliant deux côtés opposés (10,11) du rectangle, cette rainure (9) étant de largeur suffisante pour recevoir à plat une ou deux premières sangles élastiques (12A,12B) à fermeture rapide (16) qui sont respectivement fixées sur ces côtés opposés (10,11) de la plaque de base, au moins deux autres sangles ou paires de sangles de même type (13A,13B, 14A,14B, 15A,15B), mais orthogonales aux premières (12A,12B), étant par ailleurs fixées sur les deux autres côtés opposés (7,8) de cette plaque de base (2).

2. Dispositif de contention selon la revendication 1, caractérisé en ce que ladite plaque de base (2) est en bois.

3. Dispositif de contention selon la revendication 1 ou la revendication 2, caractérisé en ce que sa plaque de base (2) comprend deux prolongements latéraux (5, 6) aptes à s'enficher dans des glissières (18) prévues à cet effet dans un conteneur (4) prévu à cet effet.

4. Conteneur d'au moins un dispositif de contention (1), selon l'une des revendication 1 à 3, caractérisé en ce qu'il est équipé de plusieurs rainures (18) d'enfichage pour recevoir plusieurs de ces dispositifs de contention (1) disposés parallèlement l'un à l'autre.

## Patentansprüche

1. Universell einsetzbare Vorrichtung zum Verpacken von Elektronikkarten (17, 20, 21) oder anderen kleinen elektrischen oder elektronischen Untereinheiten gleicher Größe, die nachfolgend durchwegs "Karten" genannt werden, wobei diese Verpackungsvorrichtung (1) eine Basisplatte (2) aus antistatischem Material von allgemein rechteckiger Form und größeren Abmessungen als eine große Karte (17) aufweist und mindestens zwei Platten (3, 4) aus antistatischem Schaumstoff auf diese Basisplatte (2) derart aufgebracht sind, daß sie zwischen sich eine Nut (9) freilassen, die im wesentlichen in der Mitte verläuft und sich zwischen zwei entgegengesetzten Seiten (10, 11) des Rechtecks erstreckt sowie eine ausreichende Breite aufweist, um einen oder zwei elastische Gurte (12A, 12B) mit Schnellverschluß (16) flach aufzunehmen, die je an entgegengesetzten Seiten (10, 11) der Basisplatte befestigt sind, wobei mindestens zwei weitere Gurte oder Paare von Gurten der gleichen Art (13A, 13B, 14A, 14B, 15A, 15B), aber senkrecht zu den ersten (12A, 12B), außerdem an den beiden anderen entgegengesetzten Seiten (7, 8) dieser Basisplatte befestigt sind.

2. Vorrichtung nach Anspruch 1, dadurch gekennzeichnet, daß die Basisplatte (2) aus Holz ist.

3. Vorrichtung nach Anspruch 1 oder 2, dadurch gekennzeichnet, daß ihre Basisplatte (2) zwei seitliche Verlängerungen (5, 6) aufweist, die sich in Schienen (18) einschieben lassen, die zu diesem Zweck in einem hierfür vorgesehenen Kontainer (4) "ausgebildet sind.

4. Kontainer für mindestens eine Vorrichtung (1) gemäß einem der Ansprüche 1 bis 3, dadurch gekennzeichnet, daß er mit mehreren Einschubnuten (18) versehen ist, um mehrere dieser Vorrichtungen (1) parallel zueinander angeordnet aufzunehmen.

## Claims

1. Universal retention device for electronic circuit cards (17, 20, 21) or other small electrical or electronic subassemblies of similar size, hereinafter all referred to as "cards", said retention device (1) including a board (2) of antistatic material, generally rectangular in shape and having dimensions greater than those of a relatively large card (17), at least two sheets of antistatic foam (3, 4) attached to said board (2) in such a way as to leave a substantially median groove (9) between them linking two opposite sides (10, 11) of the rectangle, said groove (9) being of sufficient width to receive flat one or two first elastic straps (12A, 12B) with quick-action fasteners (16) respectively fixed to said opposite sides (10, 11) of the board, and at least two other straps or pairs of straps of the same type (13A, 13B; 14A, 14B; 15A, 15B) but orthogonal to the first straps (12A, 12B) fixed to the other two opposite sides (7, 8) of the board (2).

2. Retention device according to claim 1 characterised in that said board (2) is made of wood.

3. Retention device according to claim 1 or claim 2 characterised in that the board (2) has two lateral extensions (5, 6) adapted to slide in slideways (18) provided for this purpose in a container (4) designed for this purpose.

4. Container for at least one retention device (1) according to any one of claims 1 to 3 characterised in that it is provided with a plurality of grooves (18) to receive a plurality of parallel retention devices (1).
